# EUROPEAN PATENT APPLICATION

(11) **EP 2 138 608 A1**
(43) Date of publication of application: **30.12.2009**
(21) Application number: 08158899.8
(22) Date of filing: 24.06.2008
(51) Int. Cl.: C25D 9/04, C03C 17/25, H01L 31/18, H01L 31/0336

(54) **Process for preparing a transparent and conductive film on a substrate**

(71) Applicant: Nederlandse Organisatie voor Toegepast- Natuurwetenschappelijk Onderzoek TNO, 2628 VK The Hague (NL)
(72) Inventor: van Neer, Martin Karolus Petrus, 6141 AS Limbricht (NL); Hovestad, Arjan, 5231 PK 's-Hertogenbosch (NL); Spee, Carolus Ida Maria Antonius, 4706 AS Helmond (NL); Ettorre, Mauro, 2595 SZ Den Haag (NL)
(74) Representative: Hatzmann, Martin

(57) **Abstract**

The invention is directed to a wet chemical deposition process for preparing a transparent and conductive film on a substrate, which film comprises a transparent conductive oxide doped with a halogen. The invention is further directed to a substrate obtainable by said process and to an electronic device comprising said substrate.

The process of the invention comprises the steps of:
(a) providing a conductive substrate;
(b) contacting the substrate with a solution comprising a precursor of the transparent conducting oxide, an oxidising agent, and a halogen-containing compound;
(c) applying a voltage/current to the solution to enable halogen-doped transparent conducting oxide to deposit on the substrate; and
(d) recovering the substrate on which the transparent and conductive film has been deposited.

## Description

The invention is directed to a wet chemical deposition process for preparing a transparent and conductive film on a substrate, which film comprises a transparent conductive oxide doped with a halogen. The invention is further directed to a substrate obtainable by said process and to an electronic device comprising said substrate.

Transparent conductive oxides (TCOs) have an important role in products such as glazing, solar cells, displays, solid state lighting, smart windows, glass heating, etc. The attractiveness of transparent conductive oxides resides in their very good optical and electrical properties. In most of the conventional production techniques for transparent conductive oxides (such as chemical vapour deposition (CVD), physical vapour deposition (PVD), sol-gel, etc.) the deposition temperature can be more than 200 °C, even up to 700 °C. Accordingly, transparent conductive oxides are typically directly deposited on substrates that have a high thermal resistance, like glass. However, there is an increasing demand to use low temperature and cost-effective deposition methods for transparent conductive oxides, in particular for large scale production.

Wet chemical deposition processes, such as electrochemical deposition, are relatively large area production methods, which can be carried out at low temperatures. In addition, wet chemical production processes are relatively cheap, because they do not require a vacuum.

D. Lincot (Thin Solid Films 2005, 487, 40-48) and EP-A-0 933 449 describe the electrochemical deposition of undoped ZnO. Undoped transparent conductive oxides have the disadvantage of having an electrical conductivity which is for most applications too low.

M. Kemell, "Electrodeposition of CuInSe2 and doped ZnO thin films for solar cells", Academic Dissertation, Helsinki, 2003 describes the electrochemical deposition of ZnO doped with aluminium. However, the inventors found that this method does not result in the desired aluminium doped transparent conductive oxide material. Instead, a mixed oxide of zinc with aluminium is obtained.

There remains a need in the art for preparing a doped transparent conductive oxide on a substrate using a cost-effective and large area production method. The invention is directed at fulfilling this need.

Object of the invention is to provide a wet chemical deposition process for preparing a transparent and conductive film on a substrate, which film comprises a doped transparent conducting oxide.

The inventors surprisingly found that this object can be met when the transparent conductive oxide is doped with a halogen.

Accordingly, in a first aspect the present invention is directed to a wet chemical deposition process for preparing a transparent and conductive film on a substrate, which film comprises a transparent conducting oxide, said oxide being doped with a halogen, whereby the process comprises the steps of:
(a) providing a conductive substrate;
(b) contacting the substrate with a solution comprising a precursor of the transparent conducting oxide, an oxidising agent, and a halogen-containing compound;
(c) applying a voltage/current to the solution to enable halogen-doped transparent conducting oxide to deposit on the substrate; and
(d) recovering the substrate on which the transparent and conductive film has been deposited.

The inventors surprisingly found that in accordance with the invention a doped transparent conductive oxide can be prepared by a wet chemical deposition process. Contrary to the case of aluminium doped ZnO, the process of the invention does not result in a mixed oxide transparent conductive oxide, but in a halogen-doped transparent conductive oxide. Without wishing to be bound by theory, the inventors believe that this is caused by the halogen being negatively charged. Accordingly, the oxygen atoms instead of the metal atoms of the transparent conductive oxide material are exchanged for the dopant halogen atoms.

The halogen can suitably be fluorine, chlorine, iodine or bromine. Good results have been obtained using fluorine.

The conductive substrate can comprise a semiconducting material, such as a semiconducting material selected from the group consisting of elemental IV, III-V, II-VI, II-V, V-VI, and IV-VI semiconductors and alloys thereof. The semiconducting material can also be organic. Suitable organic semiconducting materials can be selected from the group consisting of polypyrrole, polyaniline, polythiophene, polyacetylene, poly(3,4-ethylenedioxythiophene), poly(3,4-ethylenedioxythiophene)-poly(styrenesulphonate) (PEDOT:PSS), Poly(3,4-ethylenedioxythiophene)-tetramethacrylate (PEDOT:TMA) and derivatives thereof.

Preferably, the semiconducting material comprises ZnO, Cu(Ga)InSe(S), Cu(Sn,Zn)Se, CdS, CdTe, Si or poly(3,4-ethylenedioxythiophene)-poly(styrenesulphonate).

In an embodiment the conductive substrate is a metal carrier. Such a metal can suitably be selected from the group consisting of Cu, Au, Ag, Pd, Pt, Ru, Ni, Co, Fe, Ti, Zn, Mo, W, Al, Sn, Mn and alloys thereof. Preferably, the metal is Cu, Au or Ni.

The metal carrier can advantageously be in the form of a metal film or foil, such as a copper, steel or nickel film or foil.

In an embodiment the substrate comprises multiple layers. The substrate can for instance comprise a photovoltaic stack comprising a stainless steel carrier, a molybdenum back contact, a chalcogenide photoabsorber (Cu(Ga)InSe(S)), a CdS buffer layer, and optionally a zinc oxide, or an OLED (organic light emitting diode) comprising a PET (polyethylene terephthalate) foil substrate, a barrier layer, a cathode, a light emitting polymer layer and a PEDOT:PSS film.

Step (b) is preferably carried out at a temperature of 50 °C or more, preferably 60 °C or more, even more preferably 65 °C or more. At temperatures below 50 °C films with inferior electrical and optical properties are deposited due to formation of hydroxide instead of oxide. The temperature during step (b) is preferably 100 °C or less, more preferably 90 °C or less, even more preferably 80 °C or less.

The pH of the solution with which the conductive substrate is contacted in step (b) is dependent on the transparent conductive oxide to be deposited.

Suitably, the solution with which the conductive substrate is contacted in step (b) has a pH value of 2-12, preferably 4-10, more preferably 5-8. A pH of 5-8 is very suitable when the transparent conductive substrate to be deposited is ZnO.

In another embodiment, the solution with which the conductive substrate is contacted in step (b) has a pH value of 0-2. A pH of 0-2 is very suitable when the transparent conductive substrate to be deposited is SnO₂.

The precursor of the transparent conductive oxide depends on the transparent conductive oxide to be prepared. Suitably, the precursor is selected from the group consisting of carbonates, borates, phosphates, nitrates, chlorides, chlorates, sulphates, persulphates, acetates, fluorides, iodides, bromides, peroxides and oxides and hydroxides.

Suitable precursors for the preparation of a ZnO transparent conductive oxide include zinc nitrate, zinc chloride, zinc bromide, zinc peroxide, zinc fluoride, zinc sulphate, zinc borate, and zinc acetate. Suitable precursors for the preparation of an In₂O₃ transparent conductive oxide include indium chloride, indium nitrate, indium sulphate, indium fluoride, indium acetate, and indium perchlorate. Suitable precursors for the preparation of a SnO₂ transparent conductive oxide include divalent and tetravalent tin sulphate, tin chloride, tin fluoride, tin acetate, and tin oxalate. Suitable precursors for the preparation of a CdO transparent conductive oxide include cadmium chloride, cadmium nitrate, cadmium perchlorate, cadmium acetate, cadmium bromide, cadmium cyanide, and cadmium sulphate. Suitable precursors for the preparation of a PbO transparent conductive oxide include lead chloride, lead acetate, lead bromide, lead fluoride, and lead nitrate. Suitable precursors for the preparation of a, NiO transparent conductive oxide include nickel chloride, nickel acetate, nickel nitrate, nickel bromide, nickel borate, nickel fluoride, and nickel sulphate. Suitable precursors for the preparation of a Co₂O₃ transparent conductive oxide include cobalt chloride, cobalt acetate, cobalt nitrate, cobalt bromide, cobalt borate, cobalt fluoride, and cobalt sulphate. Suitable precursors for the preparation of a Cu₂O transparent conductive oxide include copper chloride, copper acetate, copper nitrate, copper bromide, copper borate, copper fluoride, and copper sulphate. Suitable precursors for the preparation of a Ag₂O transparent conductive oxide include silver chloride, silver acetate, silver nitrate, silver bromide, silver borate, silver fluoride, and silver sulphate. Suitable precursors for the preparation of a Al₂O₃ transparent conductive oxide include aluminium chloride, aluminium acetate, aluminium nitrate, aluminium bromide, aluminium borate, aluminium fluoride, and aluminium sulphate. Suitable precursors for the preparation of a Ga₂O₃ include gallium chloride, gallium acetate, gallium nitrate, gallium bromide, gallium borate, gallium fluoride, and gallium sulphate.

In case a mixed oxide transparent conductive oxide is desired, it is also possible to use a solution comprising more than one transparent conductive oxide precursor.

The transparent conducting oxide can suitable selected from the group consisting of ZnO, In₂O₃, SnO₂, CdO, PbO, NiO, Co₂O₃, Cu₂O, Ag₂O, Al₂O₃, Ga₂O₃ and any mixed oxides thereof. Preferably the transparent conductive oxide comprises ZnO or Sn02.

In a preferred embodiment the precursor of the transparent conductive oxide at the same time acts as the oxidising agent. In such a case it is not necessary to use a separate oxidising agent. Examples of precursors of transparent conductive oxides that can also act as oxidising agents include nitrates, peroxides, perchlorates, chlorates, and persulphates.

The concentration of the precursors in the solution to be contacted with the conductive substrate can suitably be 0.001-1 M, preferably the concentration of the transparent conductive oxide precursor in the solution is 0.05-0.5 M, more preferably about 0.1 M.

The oxidising agent can suitably be selected from the group consisting of nitrates, chlorates, perchlorates, persulphates, oxygen and peroxides. The oxidising agent can for instance be sodium nitrate, sodium chlorate, dissolved oxygen, hydrogen peroxide, potassium persulfate, or potassium perchlorate.

The concentration of the oxidising agent in the solution to be contacted with the conductive substrate can suitably be 0.001-2 M, preferably the concentration of the oxidising agent in the solution is 0:05-1 M, more preferably about 0.5 M.

The solution to be contacted with the conductive substrate further comprises a halogen-containing compound. This halogen-containing compound can suitably be a fluorine-containing compound, such as a fluoride salt.

The halogen-containing compound can for instance be a fluorine-containing compound selected from the group consisting of monofluorides, bifluorides, boron fluorides, silicon fluorides and transition metal fluorides.

Suitable examples of monofluorides include sodium fluoride, potassium fluoride, ammonium fluoride, hydrogen fluoride, cesium fluoride, and lithium fluoride.

Suitable examples of bifluorides include ammonium hydrogen difluoride, sodium hydrogen difluoride, potassium hydrogen difluoride.

Suitable examples of boron fluorides include sodium tetrafluoroborate, potassium tetrafluoroborate, ammonium tetrafluoroborate, lithium tetrafluoroborate, and fluoroboric acid.

Suitable examples of silicon fluorides include sodium hexafluorosilicate, potassium hexafluorosilicate, ammonium hexafluorosilicate, and fluorosilicic acid.

Suitable examples of transition metal fluorides include titanium fluoride, potassium hexafluorotitanate, potassium fluorozirconate, potassium fluoro niobate, potassium fluorotungstate, potassium fluorovanadate potaasium hexafluorohafnate, hexafluorotitanic acid, hexafluorozirconic acid, and hexafluorohafnic acid.

Examples of chlorine-containing compounds include sodium chloride, ammonium chloride, and potassium chloride.

Examples of bromine-containing compounds include sodium bromide, and ammonium bromide.

Examples of iodine-containing compounds include sodium iodide, potassium iodide, potassium iodide, and ammonium iodide.

Monohalogens (monofluorides, monochlorides, monobromides, or monoiodides) are preferred, because in that case low halogen concentrations suffice. In addition, the monohalogens are preferred since the formation of other compounds (such as silicates or titanates) is undesirable.

Combinations of different halogen-containing compounds can also be used in the method of the invention, including combinations of halogen-containing compounds having different halogens.

The concentration of the halogen-containing compound in the solution to be contacted with the conductive substrate can suitably be 0.0001-0.05 M. Preferably, the concentration of the halogen-containing compound in the solution is 0.0005-0.01 M, more preferably about 0.001 M.

In step (c) a voltage or a current is applied to the solution. This enables halogen-doped transparent conducting oxide to deposit on the substrate. Typically, a voltage of -0.3 to -1.1, preferably the voltage is -0.5 to -0.9, more preferably about -0.7 V vs standard hydrogen electrode. Typically, a current density of 1-5 000 A m⁻², preferably the current density is 10-1 000 A m⁻², more preferably about 100 A m⁻².

Preferably, steps (b) and (c) together are carried out over a period of time ranging from 5-30 minutes.

Thereafter, the substrate on which the transparent and conductive film has been deposited is recovered.

With the process of the invention transparent and conductive films with an average layer thickness of 50 nm - 2 µm can be prepared.

In a further aspect the invention is directed to a substrate obtainable by a process according to the invention.

In yet a further aspect the invention is directed to an electronic device comprising a substrate obtainable by the process of the invention.

### Examples

### 1. Undoped ZnO

An ITO-coated glass substrate was cleaned in ethanol and immersed in a solution of 0.1 M zinc nitrate, Zn(NO₃) and 0.1 M potassium nitrate, KNO₃, at pH 5.5 and 80 °C. A voltage of -0.7 V vs NHE was applied on the ITO-coated glass substrate for 5 minutes resulting in a 500 nm ZnO film. The ZnO film has an electrical resistivity of approximately 20 Ωm, an optical transmission of 80 % and a maximum haze of 40 % at 350 nm.

### 2. Aluminium-doped ZnO

An ITO-coated glass substrate was cleaned in ethanol and immersed in a solution of 0.1 M zinc nitrate, Zn(NO₃)2, and 5 µM aluminium nitrate, Al(NO₃)₃, at pH 5.5 and 80 °C. A voltage of -0.7 V vs NHE was applied on the ITO-coated glass substrate for 5 minutes resulting in a 500 nm aluminium containing ZnO film. The electrical resistivity of the aluminium containing film is 150 Ωm, which is 7 times higher than the undoped ZnO film of 1 indicating that the film is not doped. Microscopic study of the aluminium containing ZnO film reveals and strongly inhomogeneous coating.

### 3. Fluorine-doped ZnO

An ITO-coated glass substrate was cleaned in ethanol and immersed in a solution of 0.1 M zinc nitrate, Zn(NO₃)₂, 0.1 M potassium nitrate, KNO₃ and 1 mM hydrogen fluoride, HF, at pH 4 and 65 °C. A voltage of -0.7 V vs NHE was applied on the ITO-coated glass substrate for 10 minutes resulting in a 200 nm ZnO:F film with a F/Zn ratio of 4 %. The film has an optical transmission of 75 % and a maximum haze of 98 % at 350 nm.

### 4. Fluorine-doped ZnO

An ITO-coated glass substrate was cleaned in ethanol and immersed in a solution of 0.1 M zinc nitrate, Zn(NO₃)₂, 0.1 M potassium nitrate, KNO₃ and 1.6 mM hydrogen fluoride, HF, at pH 4 and 65 °C. A voltage of -0.7 V vs NHE was applied on the ITO-coated glass substrate for 10 minutes resulting in a 200 nm ZnO:F film with a F/Zn ratio of 20 %. The film has an optical transmission of 75 % and a maximum haze of 92 % at 375 nm.

### 5. Fluorine-doped ZnO

An ITO-coated glass substrate was cleaned in ethanol and immersed in a solution of 0.1M zinc nitrate, Zn(NO₃)₂, 0.1 M potassium nitrate ,KNO₃ and 1.8 mM hydrogen fluoride, HF, at pH 4 and 65 °C. A voltage of -0.7 V vs NHE was applied on the ITO-coated glass substrate for 10 minutes resulting in a 350 nm ZnO:F film with a F/Zn ratio of 7 %. The film has an optical transmission of 80 % and a maximum haze of 65 % at 375 nm.

## Claims

1. A wet chemical deposition process for preparing a transparent and conductive film on a substrate, which film comprises a transparent conducting oxide, said oxide being doped with a halogen, whereby the process comprises the steps of:
(a) providing a conductive substrate;
(b) contacting the substrate with a solution comprising a precursor of the transparent conducting oxide, an oxidising agent, and a halogen-containing compound;
(c) applying a voltage/current to the solution to enable halogen-doped transparent conducting oxide to deposit on the substrate; and
(d) recovering the substrate on which the transparent and conductive film has been deposited.

2. The process according to claim 1, wherein the transparent conducting oxide is selected from the group consisting of ZnO, In₂O₃, SnO₂, CdO, PbO, NiO, Co₂O₃, Cu₂O, Ag₂O, Al₂O₃, Ga₂O₃ and any mixed oxides thereof.

3. The process according to claim 2, wherein the transparent conducting oxide comprises ZnO or SnO₂.

4. The process according to claim 1, wherein the substrate comprises a semi-conducting material or a metal film or foil.

5. The process according to claim 2, wherein the semiconducting material is selected from the group consisting of elemental IV, III-V, II-VI, II-V, V-VI, and IV-VI semiconductors and alloys thereof, and organic semiconductors.

6. The process according to claim 5, wherein the organic semiconducting material is selected from the group consisting of polypyrrole, polyaniline, polythiphene, polyacetylene, poly(3,4-ethylenedioxythiophene), poly(3,4-ethylenedioxythiophene) poly(styrenesulphonate) and derivatives thereof.

7. The process according to claim 5 or 6, wherein the semiconducting material comprises Si, Cu(Ga)InSe(S), Cu(Sn,Zn)Se, CdS, CdTe, or poly(3,4-ethylenedioxythiophene) poly(styrenesulphonate).

8. The process according to claim 4, wherein the metal is selected from the group consisting of Cu, Au, Ag, Pd, Pt, Ru, Ni, Co, Fe, Ti, Zn, Mo, W, Al, and alloys thereof.

9. The process according to claim 8, wherein the metal is Cu, Au or Ni.

10. The process according to any one of claims 1-9, wherein steps (b) and (c) are carried out at a temperature in the range of from 50-100 °C.

11. The process according to claim 10, wherein steps (b) and (c) are carried out at a temperature in the range of from 60-90 °C.

12. The process according to any one of claims 1-11, wherein the solution has a pH value in the range of from 2-12.

13. The process according to claim 12, wherein the solution has a pH value in the range of from 5-8.

14. The process according to any one of claims 1-11, wherein the solution has a pH value in the range of 0-2.

15. The process according to any one of claims 1-14, wherein the precursor is present in a concentration of 0.001-1 M.

16. The process according to any one of claims 1-15, wherein the precursor(s) is (are) selected from the group consisting of nitrates, chlorides, sulphates, acetates, fluorides, iodides, bromides and hydroxides.

17. The process according to any one of claims 1-16, wherein the oxidising agent is present in a concentration of 0.001-2 M.

18. The process according to any one of claims 1-17, wherein the oxidising agent is selected from the group consisting of nitrates, chlorates, oxygen and peroxides.

19. The process according to any one of claims 1-18, wherein the halogen-containing compound is present in a concentration of 0.0001-0.05 M.

20. The process according to any one of claims 1-19, wherein the halogen is fluorine.

21. The process according to claim 20, wherein the halogen-containing compound is selected from the group consisting of monofluorides, bifluorides, boron fluorides, silicon fluorides and transition metal fluorides.

22. The process according to any one of claims 1-21, wherein steps (b) and (c) are together being carried out over a period of time ranging from 5-30 minutes.

23. A substrate obtainable by the process according to any one of claims 1-22.

24. An electronic device comprising a substrate according to claim 23.
